# EUROPÄISCHE PATENTSCHRIFT

(11) **EP 1 034 100 B1**
(45) Veröffentlichungstag und Bekanntmachung des Hinweises auf die Patenterteilung: **29.10.2003**
(21) Anmeldenummer: 98963378.9
(22) Anmeldetag: 25.11.1998
(51) Int. Cl.: B60R 25/00, B60R 25/04, E05B 49/00

(54) **Steuerung für ein Kraftfahrzeug mit Fernbedienung oder Transponder**
Control Device for a Motor Vehicle with a Remote Control or Transponder
Dispositif de commande pour véhicule avec commande à distance ou transpondeur

(30) Priorität: 26.11.1997 DE 19752278
(43) Veröffentlichungstag der Anmeldung: 13.09.2000
(73) Patentinhaber: ROBERT BOSCH GMBH, 70442 Stuttgart (DE)
(72) Erfinder: WEIGL, Andreas, D-76351 Linkenheim-Hochstetten (DE)
(86) Internationale Anmeldenummer: DE9803464
(87) Internationale Veröffentlichungsnummer: WO99028169

(56) Entgegenhaltungen:
- EP-A- 0 501 165
- EP-A- 0 607 873
- EP-A- 0 616 101
- DE-A- 3 109 577
- DE-C- 4 422 992
- US-A- 4 737 784

## Beschreibung

Die Erfindung betrifft eine Steuerung in einem Kraftfahrzeug mit Fernbedienung oder Transponder zur Übertragung von Informationen an einen im Kraftfahrzeug untergebrachten Empfänger, bei der die Fernbedienung oder der Transponder eine Batterie oder einen Akkumulator mit einer Überwachungseinheit für den Ladezustand der Batterie oder des Akkumulators aufweist und eine Ladezustandskennung zum Kraftfahrzeug überträgt und dort zur Anzeige bringt.

Eine Steuerung dieser Art in einem Kraftfahrzeug ist aus der US-A 4,737,784 bekannt. Dabei wird von der Überwachungseinheit ein Alarmsignal ausgesandt, wenn der Ladezustand der Batterie unter einen vorgegebenen Wert absinkt. Der Benutzer des Kraftfahrzeuges wird erst dann auf den evtl. nicht mehr ausreichenden Ladezustand der Batterie aufmerksam gemacht, wenn das Nichtfunktionieren der Steuerung unmittelbar bevorsteht. Zudem wird die Batterie durch die Überwachungseinheit stets belastet.

Wie die EP 0 607 873 A2 und die EP 0 616 101 A1 zeigen, ist auch bekannt, bei einem Fahrzeug-Schließsystem mit einem Sender/Schlüssel die aktuelle Spannung der Energiequelle desselben festzustellen und dem Benutzer eine warnende Anzeige zukommen zu lassen, wenn diese Spannung deutlich nachgelassen hat oder zumindest nachzulassen droht. Dabei können zwei definierte Spannungswerte erfasst und angezeigt werden.

Bei einer Spannungsüberwachung der Energiequelle eines Senders ist es zudem bekannt, die Anzeige des Ladezustandes im Sender selbst vorzunehmen. Dies ist aber bei kleinen, tragbaren Sendern, wie Fernbedienungen und Transpondern aus Platzgründen bei einer Steuerung in einem Kraftfahrzeug nicht sinnvoll.

Es ist Aufgabe der Erfindung, eine Steuerung der eingangs erwähnten Art zu schaffen, bei der in der Fernbedienung oder im Transponder keine Anzeigeeinrichtung erforderlich ist, die Überwachungseinheit nur bei der Abgabe von Ladezustandskennungen Energie der Batterie oder des Akkumulators entnimmt und der Benutzer ausreichend Gelegenheit bekommt, den kritischen Ladezustand der Energiequelle in der Fernsteuerung oder dem Transponder zu erkennen.

Diese Aufgabe wird nach der Erfindung dadurch gelöst, dass die Überwachungseinheit beim Aussenden eines Steuerbefehls aktivierbar ist, den jeweiligen Ladezustand der Batterie oder des Akkumulators erfasst und dem Steuerbefehl eine entsprechende Ladezustandskennung zufügt und dass die vom Empfänger im Kraftfahrzeug ausgewertete Ladezustandskennung eine vorgegebene Zeit lang aufrecht erhalten wird.

Da die Überwachungseinheit in der Fernsteuerung oder in dem Transponder nur bei der Aussendung eines Steuerbefehls aktiviert wird, benötigt sie nur kurzzeitig Energie zur Erfassung des Ladezustandes und Zuordnung einer entsprechenden Ladezustandskennung, die dem Steuerbefehl zugefügt wird. Die Anzeige erfolgt im Kraftfahrzeug und wird zur ausreichenden Erkennung durch den Benutzer eine vorgegebene Zeit aufrecht erhalten. Dies ist für die Energiequelle der Fernsteuerung oder des Transponders unkritisch, da die Energie dafür der Batterie des Kraftfahrzeuges entnommen wird.

In der Fernbedienung oder in dem Transponder ist keine Anzeige für den Ladezustand nötig. Es ist dort kein Platz für die Anzeige vorzusehen, so dass die Fernsteuerung oder der Transponder kleiner und robuster aufgebaut werden kann.

Nach einer Ausgestaltung ist vorgesehen, dass die Überwachungseinheit als Grenzwertgeber ausgebildet ist, der einen ausreichenden Ladezustand und einen nicht ausreichenden Ladezustand kennzeichnet und als zugeordnete Ladezustandskennungen zum Empfänger im Kraftfahrzeug überträgt und zur Anzeige bringt.

Diese Überwachungseinheit ist in vielen Fällen ausreichend. Das "Gutsignal" zeigt an, daß für die Steuerung ausreichender Ladezustand der Batterie oder des Akkumulators in der Fernbedienung oder im Transponder vorhanden ist, während das "Schlechtsignal" auf die Notwendigkeit des Austausches der Batterie oder des Aufladens des Akkumulators hinzuweisen, die Funktionsfähigkeit jedoch nicht zu gewährleisten vermag.

Die Anzeige des Ladezustandes kann nach einer weiteren Ausgestaltung dadurch noch variiert und abgestuft werden, daß die Überwachungseinheit mehrere Ladezustände erfaßt und als entsprechende Ladezustandskennungen zum Empfänger im Kraftfahrzeug überträgt und zur Anzeige bringt.

Die Anzeige im Kraftfahrzeug erfolgt vorzugsweise im Armaturenbrett, so daß der Nutzer dieses rechtzeitig und deutlich erkennen kann. Dabei ist es von Vorteil, wenn die Anzeige des Ladezustandes der Batterie oder des Akkumulators in der Fernbedienung oder dem Transponder nach jeder Aussendung eines Steuerbefehls mit Ladezustandskennung im Kraftfahrzeug eine vorgegebene Zeit lang aufrechterhalten wird.

## Patentansprüche

1. Steuerung in einem Kraftfahrzeug mit Fernbedienung oder Transponder zur Übertragung von Informationen an einen im Kraftfahrzeug untergebrachten Empfänger, bei der die Fernbedienung oder der Transponder eine Batterie oder einen Akkumulator mit einer Überwachungseinheit für den Ladezustand der Batterie oder des Akkumulators aufweist und eine Ladezustandskennung zum Kraftfahrzeug überträgt und dort zur Anzeige bringt,
**dadurch gekennzeichnet,**
**dass** die Überwachungseinheit erst beim Aussenden eines Steuerbefehls aktivierbar ist, den jeweiligen Ladezustand der Batterie oder des Akkumulators erfasst und dem Steuerbefehl eine entsprechende Ladezustandskennung zufügt und
**dass** die vom Empfänger im Kraftfahrzeug ausgewertete Ladezustandskennung eine vorgegebene Zeit lang aufrecht erhalten wird.

2. Steuerung nach Anspruch 1,
**dadurch gekennzeichnet,**
**dass** die Überwachungseinheit als Grenzwertgeber ausgebildet ist, der einen ausreichenden Ladezustand und einen nicht ausreichenden Ladezustand kennzeichnet und als zugeordnete Ladezustandskennungen zum Empfänger im Kraftfahrzeug überträgt und zur Anzeige bringt.

3. Steuerung nach Anspruch 1,
**dadurch gekennzeichnet,**
**dass** die Überwachungseinheit mehrere definierte Ladezustände erfasst und als entsprechende Ladezustandskennungen zum Empfänger im Kraftfahrzeug überträgt und zur Anzeige bringt.

## Claims

1. Control device in a motor vehicle with a remote control or transponder for transmitting information to a receiver which is accommodated in the motor vehicle, in which the remote control or the transponder has a battery or an accumulator battery with a monitoring unit for the charge state of the battery or of the accumulator battery and transmits a charge state identifier to the motor vehicle and displays it there, **characterized in that** only when a control instruction has been emitted can the monitoring unit be activated and said monitoring unit senses the respective charge state of the battery or of the accumulator battery and adds a corresponding charge state identifier to the control instruction, and **in that** the charge state identifier which is evaluated by the receiver in the motor vehicle is maintained for a predefined time period.

2. Control device according to Claim 1, **characterized in that** the monitoring unit is embodied as a limiting value signal transmitter which characterizes a sufficient charge state and an insufficient charge state and transmits them as assigned charge state identifiers to the receiver in the motor vehicle and displays them.

3. Control device according to Claim 1, **characterized in that** the monitoring unit senses a plurality of defined charge states and transmits them as corresponding charge state identifiers to the receiver in the motor vehicle and displays them.

## Revendications

1. Dispositif de commande pour véhicule avec commande à distance ou transpondeur pour transférer des informations à un récepteur intégré dans le véhicule, dans lequel la commande à distance ou le transpondeur présente une batterie ou un accumulateur avec une unité de surveillance de l'état de charge de la batterie ou de l'accumulateur et transmet au véhicule un signal identifiable de l'état de charge et l'y affiche,
**caractérisé en ce que**
l'unité de surveillance ne peut être activée qu'à l'émission d'une instruction de contrôle, elle détermine l'état de charge de la batterie ou de l'accumulateur et elle ajoute à l'instruction de contrôle un signal identifiable correspondant de l'état de charge, et
le signal identifiable de l'état de charge évalué par le récepteur dans le véhicule est conservé pendant une durée prédéfinie.

2. Dispositif selon la revendication 1,
**caractérisé en ce que**
l'unité de surveillance est élaborée sous la forme d'un transmetteur de valeur limite qui identifie un état de charge suffisant et un état de charge insuffisant, transmet l'identification de cet état au récepteur dans le véhicule sous forme de signaux identifiables selon de l'état de charge et l'affiche.

3. Dispositif selon la revendication 1,
**caractérisé en ce que**
l'unité de surveillance comprend plusieurs états de charge définis qu'elle transmet au récepteur dans le véhicule sous forme de signaux correspondants identifiables de l'état de charge et l'affiche.
